# EUROPEAN PATENT APPLICATION

(11) **EP 4 220 955 A1**
(43) Date of publication of application: **02.08.2023**
(21) Application number: 23151006.6
(22) Date of filing: 10.01.2023
(51) Int. Cl.: H03H 3/02, H03H 9/02, H03H 3/04

(54) **ACOUSTIC WAVE RESONATOR WITH LOW/ZERO-ELECTROMECHANICAL COUPLING AT BORDER REGION**

(30) Priority: 11.01.2022 US 202263298248 P; 29.03.2022 US 202263324961 P; 05.01.2023 US 202318150621
(71) Applicant: Qorvo US, Inc., Greensboro, NC 27409 (US)
(72) Inventor: KOOHI, Milad Zolfagharloo, Florida 32703 (US); FATTINGER, Gernot, Flordia 32703 (US); STOKES, Paul, Flordia 32703 (US); ROTHEMUND, Ralph, Flordia 32703 (US); SADHU, Jyothi Swaroop, Flordia 32703 (US); VERES, Istvan, Flordia 32703 (US)
(74) Representative: D Young & Co LLP

(57) **Abstract**

The present disclosure relates to a Bulk Acoustic Wave, BAW, resonator (30), which includes a bottom electrode (32), a top electrode structure (34), and a ferroelectric layer (36) sandwiched in between. Herein, the ferroelectric layer is formed of a ferroelectric material, which has a box-shape polarization-electric field, P-E, curve. The ferroelectric layer includes a ferroelectric border, BO, portion (40) positioned at a periphery of the ferroelectric layer and a ferroelectric central portion (36_C) surrounded by the ferroelectric BO portion. The ferroelectric BO portion has a first polarization (P_{BO}) and a first electromechanical coupling coefficient, and the ferroelectric central portion has a second polarization (P_{NON}) and a second electromechanical coupling coefficient. An absolute value of the first polarization is less than an absolute value of the second polarization, and the first electromechanical coupling coefficient is less than the second electromechanical coupling coefficient. The ferroelectric central portion is configured to provide a resonance of the BAW resonator.

## Description

### Related Applications

This application claims the benefit of provisional patent application serial number 63/298,248, filed January 11, 2022, and provisional patent application serial number 63/324,961, filed March 29, 2022, the disclosures of which are hereby incorporated herein by reference in their entireties.

### Field of the Disclosure

The present disclosure relates to a Bulk Acoustic Wave (BAW) resonator with zero or low electromechanical coupling at a border region of the BAW resonator, and a process for making the same.

### Background

Due to their small size, high Q values, and very low insertion losses at microwave frequencies, particularly those above 1.5 Gigahertz (GHz), Bulk Acoustic Wave (BAW) filters have been widely used in many modern wireless applications. For instance, the BAW filters incorporating BAW resonators are the filter of choice for many 3^{rd} Generation (3G) and 4^{th} Generation (4G) wireless devices, and are destined to dominate filter applications for 5^{th} Generation (5G) wireless devices.

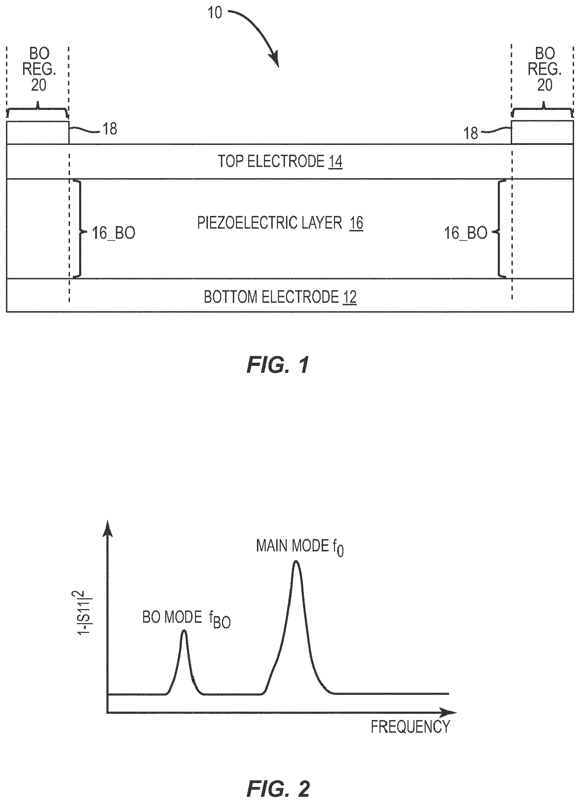

One example of a conventional BAW resonator 10 is illustrated in Figure 1. The BAW resonator 10 includes a bottom electrode 12, a top electrode 14, and a piezoelectric layer 16 (which is sometimes referred to as a transduction layer) sandwiched between the bottom electrode 12 and the top electrode 14. Because of a finite lateral dimension of the BAW resonator 10, lateral wave spurious modes may be excited in the BAW resonator 10, which results in degradation of the quality factor (Q) of the BAW resonator 10. In this regard, a border (BO) ring 18 is introduced to be included in the BAW resonator 10 to confine the energy inside the BAW resonator 10 and prevent the excitation of undesired lateral wave spurious modes. The BO ring 18 is over a top surface of the top electrode 14 around a periphery of the top electrode 14 within what is referred to herein as a BO region 20 of the BAW resonator 10.

Although the BO ring 18 effectively eliminates the lateral wave spurious modes, the BO ring 18 will cause an undesired BO spurious resonance mode near the main resonance of the device. The main cause for the excitation of the BO spurious resonance mode is a nonzero electromechanical coupling coefficient *Kₑ²* of the piezoelectric layer 16 within the BO region 20 (i.e., piezoelectric BO portions 16_BO). Figure 2 shows a typical 1-|S₁₁|² response (1-|S₁₁|² is equal to the power ratio lost in a resonator) of the BAW resonator 10 with the BO ring 18. The frequency difference between the main resonance and the BO spurious resonance mode depends on a thickness and width of the BO ring 18 and the frequency of the main resonance (e.g., less than 100MHz). The undesired BO spurious resonance mode increases the transmission loss of filters that incorporate the BAW resonator 10.

### Summary

Particular aspects are set out in the appended independent claims. Various optional embodiments are set out in the dependent claims.

Some approaches described herein may seek to provide BAW resonator designs to reduce or eliminate the BO spurious resonance mode in the BAW resonator, while retaining high Q and low/no lateral wave spurious mode. Further, some approaches described herein may seek to keep the final product cost effective

The present disclosure relates to a Bulk Acoustic Wave (BAW) resonator with zero or low electromechanical coupling at a border region of the BAW resonator, and a process for making the same. The disclosed BAW resonator includes a bottom electrode, a top electrode structure, and a ferroelectric layer sandwiched between the bottom electrode and the top electrode structure. Herein, the ferroelectric layer is formed of a ferroelectric material, which has a box-shape polarization-electric field (P-E) curve. The ferroelectric layer includes a ferroelectric border (BO) portion positioned at a periphery of the ferroelectric layer and a ferroelectric central portion surrounded by the ferroelectric BO portion. The ferroelectric BO portion has a first polarization and a first electromechanical coupling coefficient, and the ferroelectric central portion has a second polarization and a second electromechanical coupling coefficient. An absolute value of the first polarization is less than an absolute value of the second polarization, and the first electromechanical coupling coefficient is less than the second electromechanical coupling coefficient. The ferroelectric central portion is configured to provide a resonance of the BAW resonator.

In one embodiment of the disclosed BAW resonator, the absolute value of the first polarization is constant, and the first electromechanical coupling coefficient is constant.

In one embodiment of the disclosed BAW resonator, the first polarization of the ferroelectric BO portion is a zero polarization, and the first electromechanical coupling coefficient of the ferroelectric BO is a zero electromechanical coupling coefficient.

In one embodiment of the disclosed BAW resonator, the absolute value of the first polarization gradually reduces from an interior side of the ferroelectric BO portion towards an outer edge of the ferroelectric BO portion, and the first electromechanical coupling coefficient gradually reduces from the interior side of the ferroelectric BO portion towards the outer edge of the ferroelectric BO portion.

In one embodiment of the disclosed BAW resonator, the top electrode structure includes a top electrode base over the ferroelectric layer and a BO ring protruding from a periphery of the top electrode base. Herein, a region of the BAW resonator, within which the BO ring is located is a BO region. The ferroelectric BO portion is confined within the BO region and aligned underneath the BO ring, while the ferroelectric central portion is not covered by the BO ring.

In one embodiment of the disclosed BAW resonator, the top electrode structure has a flat shape.

In one embodiment of the disclosed BAW resonator, the ferroelectric material is scandium aluminum nitride (ScₓAl₁₋ₓN) and the P-E curve of ScₓAl₁₋ₓN is dependent on a scandium concentration x.

According to one embodiment, the disclosed BAW resonator further includes a bottom Brag reflector formed underneath the bottom electrode, and a top Brag reflector formed over the top electrode structure.

According to an example process, an initial resonator precursor, which includes a bottom electrode, an initial ferroelectric layer over the bottom electrode, and a bias electrode ring over a periphery of a top surface of the initial ferroelectric layer, is firstly provided. Herein, a region of the initial resonator precursor, within which the bias electrode ring is located is a BO region. The initial ferroelectric layer is formed of a ferroelectric material, which has a box-shape P-E curve. The initial ferroelectric layer has an initial polarization. The initial ferroelectric layer includes an initial ferroelectric BO portion, which is confined within the BO region and aligned underneath the bias electrode ring, and a ferroelectric central portion, which is surrounded by the initial ferroelectric BO portion and not covered by the bias electrode ring. Next, a direct current (DC) bias voltage is applied between the bias electrode ring and the bottom electrode to convert the initial ferroelectric layer to a ferroelectric layer, which includes a ferroelectric BO portion converted from the initial ferroelectric BO portion and the ferroelectric central portion surrounded by the ferroelectric BO portion. The ferroelectric central portion remains the initial polarization and is configured to provide a resonance of the BAW resonator. Herein, the DC bias voltage is selected, such that an electric field between the bias electrode ring and the bottom electrode leads to a polarization within the ferroelectric BO portion having an absolute value less than an absolute value of the initial polarization within the ferroelectric central portion.

According to one embodiment, the process further includes removing the DC bias voltage, and forming one or more electrode layers over the top surface of the ferroelectric layer. Herein, the one or more electrode layers extend over the bias electrode ring, and a combination of the one or more electrode layers and the bias electrode ring composes a top electrode structure over the top surface of the ferroelectric layer.

According to one embodiment, the process further includes removing the DC bias voltage, removing the bias electrode ring to completely expose the top surface of the ferroelectric layer, and forming a top electrode structure over the top surface of the ferroelectric layer. Herein, the top electrode structure has a flat shape.

In one embodiment of the process, after the DC bias voltage is applied, the absolute value of the polarization within the ferroelectric BO portion is constant.

In one embodiment of the process, the polarization within the ferroelectric BO portion is a zero polarization.

In one embodiment of the process, the ferroelectric material is scandium aluminum nitride (ScₓAl₁₋ₓN) and the P-E curve of ScₓAl₁₋ₓN is dependent on a scandium concentration x.

In one embodiment of the process, the bias electrode ring includes a dielectric portion with a sloped profile and a conducting portion. The dielectric portion is deposited on the top surface of the initial ferroelectric layer within the BO region, and is configured to modify the electric field intensity throughout the initial ferroelectric BO portion when the DC bias voltage is applied.

In one embodiment of the process, a height of the dielectric portion gradually decreases from an interior side of the bias electrode ring towards an outer edge of the bias electrode ring.

In one embodiment of the process, after the DC bias voltage is applied, the absolute value of the polarization within the ferroelectric BO portion gradually reduces from an interior side of the ferroelectric BO portion towards an outer edge of the ferroelectric BO portion.

In one embodiment of the process, the dielectric portion is formed of at least one of silicon nitride (SiN) and silicon oxide (SiO₂). The conducting portion is formed over the dielectric portion and formed of at least one metal or alloy. In addition, the process further includes removing the DC bias voltage, removing the bias electrode ring to completely expose the top surface of the ferroelectric layer, and forming a top electrode structure over the top surface of the ferroelectric layer. Herein, the top electrode structure has a flat shape.

According to an example system having at least one BAW resonator with zero or low electromechanical coupling at a border region of the at least one BAW resonator, the system includes a radio-frequency (RF) input circuitry, a RF output circuitry; and a filter circuitry that includes the at least one BAW resonator. The filter circuitry is connected between the RF input circuitry and the RF output circuitry. Herein, the at least one BAW resonator includes a bottom electrode, a top electrode structure, and a ferroelectric layer sandwiched between the bottom electrode and the top electrode structure. The ferroelectric layer is formed of a ferroelectric material, which has a box-shape P-E curve. The ferroelectric layer includes a ferroelectric BO portion positioned at a periphery of the ferroelectric layer and a ferroelectric central portion surrounded by the ferroelectric BO portion. The ferroelectric BO portion has a first polarization and a first electromechanical coupling coefficient, and the ferroelectric central portion has a second polarization and a second electromechanical coupling coefficient. An absolute value of the first polarization is less than an absolute value of the second polarization, and the first electromechanical coupling coefficient is less than the second electromechanical coupling coefficient. The ferroelectric central portion is configured to provide a resonance of the BAW resonator.

In another aspect, any of the foregoing aspects individually or together, and/or various separate aspects and features as described herein, may be combined for additional advantage. Any of the various features and elements as disclosed herein may be combined with one or more other disclosed features and elements unless indicated to the contrary herein.

Those skilled in the art will appreciate the scope of the present disclosure and realize additional aspects thereof after reading the following detailed description of various illustrative embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure.
Figure 1 illustrates a cross-section view of a conventional Bulk Acoustic Wave (BAW) resonator.
Figure 2 illustrates a typical 1-|S₁₁|² response of the BAW resonator shown in Figure 1.
Figure 3A illustrates an example polarization-electric field (P-E) curve of one ferroelectric material.
Figure 3B illustrates example different P-E curves of scandium aluminum nitride (ScAlN) dependency on scandium concentration.
Figure 4 illustrates a ferroelectric-based BAW resonator with zero or low electromechanical coupling at a border region according to some embodiments of the present disclosure.
Figure 5 illustrates a 1-|S₁₁|² response of the ferroelectric-based BAW resonator shown in Figure 4.
Figures 6A-6C illustrate an example procedure to implement the ferroelectric-based BAW resonator shown in Figure 4.
Figures 7A-7B illustrate an alternative procedure to implement an alternative BAW resonator according to some embodiments of the present disclosure.
Figures 8A-8D illustrate a second alternative procedure to implement a second alternative BAW resonator according to some embodiments of the present disclosure.
Figures 9-10 illustrate other alternative BAW resonators according to some embodiments of the present disclosure.
Figure 11 illustrates a block diagram of an example system that includes at least one BAW filter which is implemented by one or more ferroelectric-based BAW resonators.
Figure 12 illustrates a block diagram of example user elements that include at least one BAW filter which is implemented by one or more ferroelectric-based BAW resonators.

It will be understood that for clear illustrations, Figures 1-12 may not be drawn to scale.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments are described herein with reference to schematic illustrations of embodiments of the disclosure. As such, the actual dimensions of the layers and elements can be different, and variations from the shapes of the illustrations as a result, for example, of manufacturing techniques and/or tolerances, are expected. For example, a region illustrated or described as square or rectangular can have rounded or curved features, and regions shown as straight lines may have some irregularity. Thus, the regions illustrated in the figures are schematic and their shapes are not intended to illustrate the precise shape of a region of a device and are not intended to limit the scope of the disclosure. Additionally, sizes of structures or regions may be exaggerated relative to other structures or regions for illustrative purposes and, thus, are provided to illustrate the general structures of the present subject matter and may or may not be drawn to scale. Common elements between figures may be shown herein with common element numbers and may not be subsequently re-described.

An electromechanical coupling coefficient *Kₑ²* of a Bulk Acoustic Wave (BAW) resonator, such as a thin film bulk acoustic resonator (FBAR) or a solidly mounted resonator (SMR), is a function of a piezoelectric coefficient d of a transduction layer of the BAW resonator, and the piezoelectric coefficient d is proportional to a polarization P of the transduction layer of the BAW resonator. Therefore, once the polarization P of the transduction layer varies, the piezoelectric coefficient d will change accordingly, and consequently, the electromechanical coupling coefficient *Kₑ²* of the BAW resonator will change as well.

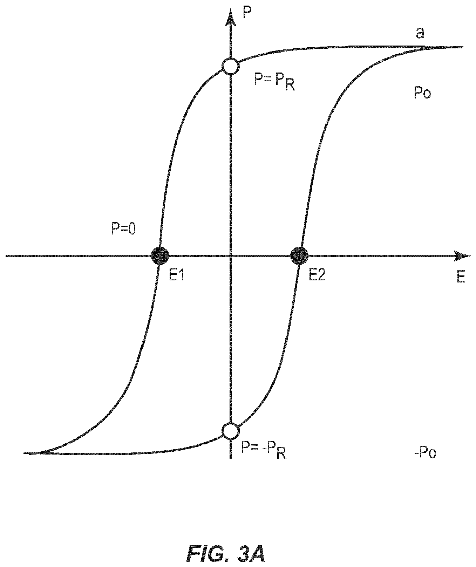

Figure 3A illustrates a simplified polarization-electric field (P-E) curve (i.e., hysteresis loop) of a ferroelectric material (herein, e.g., scandium aluminum nitride). It is clear that the polarization P of the ferroelectric material can be adjusted by changing the electric field E across the ferroelectric material. A variation amount of the polarization P is determined according to a variation amount of the electric field across the ferroelectric material. Herein, changing the electric field across the ferroelectric material may be implemented by applying different direct current (DC) bias voltages to the ferroelectric material. By applying a particular DC bias voltage to the ferroelectric material, the polarization P of the ferroelectric material can achieve a particular value. Each DC bias voltage corresponds to one polarization, depending on a previously applied electric field (i.e., previously applied DC bias voltage). For instance (e.g., moving in a counterclockwise direction), changing the electric field across the ferroelectric material from 0 to E1 (i.e., by applying a particular DC bias voltage to the ferroelectric material), the polarization *P* of the ferroelectric material can be moved from *P*=*P_{R}* to *P*=*0.* As such, the piezoelectric coefficient d of the ferroelectric material can be zero, and the electromechanical coupling coefficient *Kₑ²* of the BAW resonator that utilizes the ferroelectric material in the transduction layer, can be zero. In another instance (e.g., moving in a counterclockwise direction), changing the electric field across the ferroelectric material from E1 to 0, the polarization P of the ferroelectric material can be moved from *P*=*0* to *P*= *-P_{R}.*

Notice that, once the polarization P of the ferroelectric material becomes zero (the electromechanical coupling coefficient *Kₑ²* achieves zero), there is no need to retain the DC bias voltage applied to the ferroelectric material. After removing the DC bias voltage, the polarization P of the ferroelectric material will remain at zero (the electromechanical coupling coefficient *Kₑ²* of the ferroelectric material will remain at zero), until another DC bias voltage is applied to the ferroelectric material.

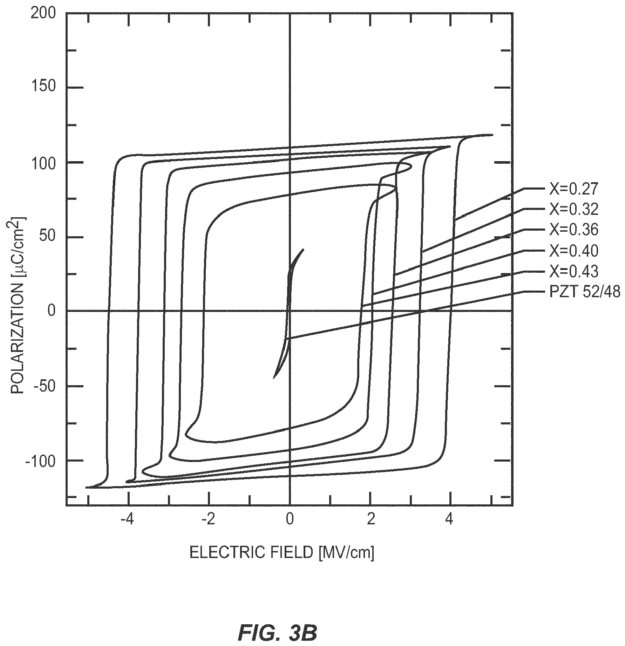

Scandium aluminum nitride (ScₓAl₁₋ₓN) is an example ferroelectric material. Figure 3B illustrates example different P-E curves of ScₓAl₁₋ₓN dependency on a scandium concentration x. When the scandium concentration x=0.27, the electric field E across ScₓAl₁₋ₓN requires -4.5/4 MV/cm to achieve the polarization P of ScₓAl₁₋ₓN equal to zero; when the scandium concentration x=0.32, the electric field E across ScₓAl₁₋ₓN requires -3.8/3.3 MV/cm to achieve the polarization P of ScₓAl₁₋ₓN equal to zero; when the scandium concentration x=0.36, the electric field E across ScₓAl₁₋ₓN requires -3/2.5 MV/cm to achieve the polarization P of ScₓAl₁₋ₓN equal to zero; when the scandium concentration x=0.40, the electric field E across ScₓAl₁₋ₓN requires -2.6/2.1 MV/cm to achieve the polarization P of ScₓAl₁₋ₓN equal to zero; and when the scandium concentration x=0.43, the electric field E across ScₓAl₁₋ₓN requires -2.2/1.8 MV/cm to achieve the polarization P of ScₓAl₁₋ₓN equal to zero (moving in a counterclockwise direction in the P-E curves). It is clear that for a zero polarization (P=0), different scandium concentrations x require different values of the electric field E across ScₓAl₁₋ₓN, thus requiring different values of the DC bias voltage applied to ScₓAl₁₋ₓN. The higher the scandium concentration x, the lower absolute value of the DC bias voltage needed for zero polarization (i.e., the lower value of the electric field E across ScₓAl₁₋ₓN). These electric field E values can change and depend on the deposition condition of the ferroelectric material (e.g., ScₓAl₁₋ₓN).

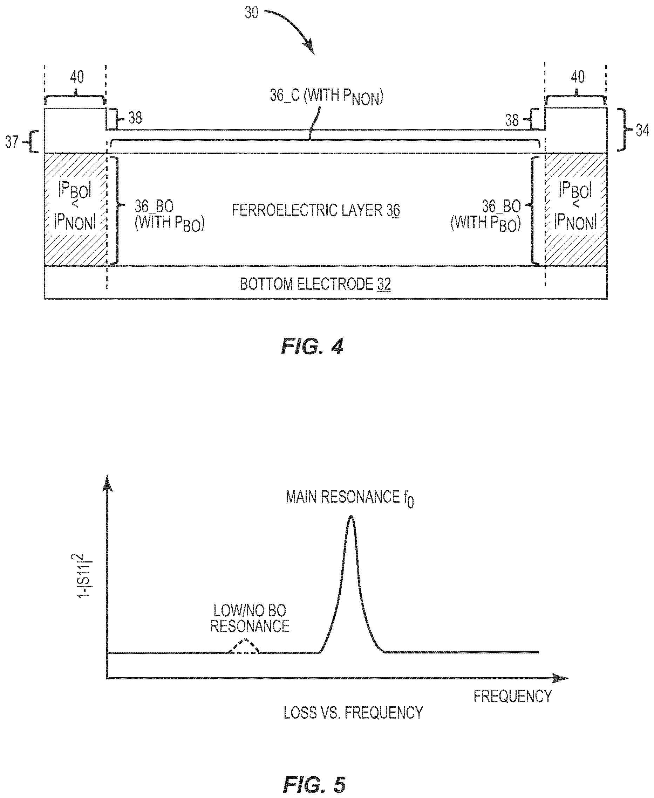

Figure 4 illustrates a ferroelectric-based BAW resonator 30 with zero or low electromechanical coupling at a border region according to some embodiments of the present disclosure. The ferroelectric-based BAW resonator 30 includes a bottom electrode 32, a top electrode structure 34, and a ferroelectric layer 36 sandwiched between the bottom electrode 32 and the top electrode structure 34.

In detail, the bottom electrode 32 may be composed of one or more electrode layers (not shown) and includes at least one metal or alloy, such as Tungsten, Aluminum Copper, and the like. The top electrode structure 34 includes a top electrode base 37 over the ferroelectric layer 36 and a border (BO) ring 38 protruding from a periphery of the top electrode base 37. Notably, a region of the ferroelectric-based BAW resonator 30, within which the BO ring 38 is located is referred to herein as a BO region 40. The top electrode base 37 may be composed of one or more electrode layers (not shown) and includes at least one metal or alloy, such as Tungsten, Aluminum Copper, and the like. The BO ring 38 may be composed of one or more ring layers (not shown) and includes at least one metal or alloy, such as Tungsten, Aluminum Copper, and the like. The bottom electrode 32 and the top electrode base 37 each has a thickness depending on the main resonant frequency of the ferroelectric-based BAW resonator 30. The BO ring 38 is configured to confine the energy inside the ferroelectric-based BAW resonator 30 (i.e., inside the ferroelectric layer 36) and prevent laterally propagating standing waves.

The ferroelectric layer 36 is formed of a ferroelectric material, which has a box-shape P-E curve (e.g., as shown in Figure 3A), such as ScₓAl₁₋ₓN, Lead Zirconate Titanate (PZT), Lead titanate (PTO), Barium Titanate (BTO), Hafnium Oxide (HfO₂) or the like. In one embodiment, when the ferroelectric layer 36 is formed of ScₓAl₁₋ₓN, the scandium concentration x might be between 0.1 and 0.8, such as x=0.27, x=0.32, x=0.36, x=0.40, or x=0.43. Herein, the ferroelectric layer 36 includes a ferroelectric BO portion 36_BO, which is confined within the BO region 40 and aligned underneath the BO ring 38, and a ferroelectric central portion 36_C, which is surrounded by the ferroelectric BO portion 36_BO and not covered by the BO ring 38. The ferroelectric BO portion 36_BO has a zero/small polarization *Peo* and the ferroelectric central portion 36_C has a nonzero polarization *P_{NON},* where an absolute value of the polarization of the ferroelectric BO portion 36_BO is less than an absolute value of the polarization of the ferroelectric central portion 36_C (|*P_{BO}*|< |*P_{NON}*|). Thus, the ferroelectric BO portion 36_BO has a zero/small electromechanical coupling coefficient *K_{e_BO}²,* which is less than a nonzero electromechanical coupling coefficient *K_{G_NON}²* of the ferroelectric central portion 36_C. Due to the zero/small electromechanical coupling coefficient *K_{e_BO}²* of the ferroelectric BO portion 36_BO, there will be no or low BO spurious resonance modes in the ferroelectric-based BAW resonator 30. In addition, the zero/small polarization *Peo* of the ferroelectric BO portion 36_BO (the zero/small electromechanical coupling coefficient *K_{e_BO}²* of the ferroelectric BO portion 36_BO) can also help confine the energy inside the ferroelectric-based BAW resonator 30 and reduce laterally propagating standing waves. The ferroelectric central portion 36_C, which has the nonzero electromechanical coupling coefficient *K_{e_NON}²,* is configured to provide a main resonance of the ferroelectric-based BAW resonator 30 (when an alternating current voltage is applied between the top electrode structure 34 and the bottom electrode 32).

Figure 5 shows a 1-|S₁₁|² response (1-|S₁₁|² is equal to the power ratio lost in a resonator) of the ferroelectric-based BAW resonator 30. The undesired BO spurious resonance (which is caused by the BO ring 38) near the main resonance of the ferroelectric-based BAW resonator 30 is eliminated/significantly compressed, while the main resonance of the ferroelectric-based BAW resonator 30 is barely affected.

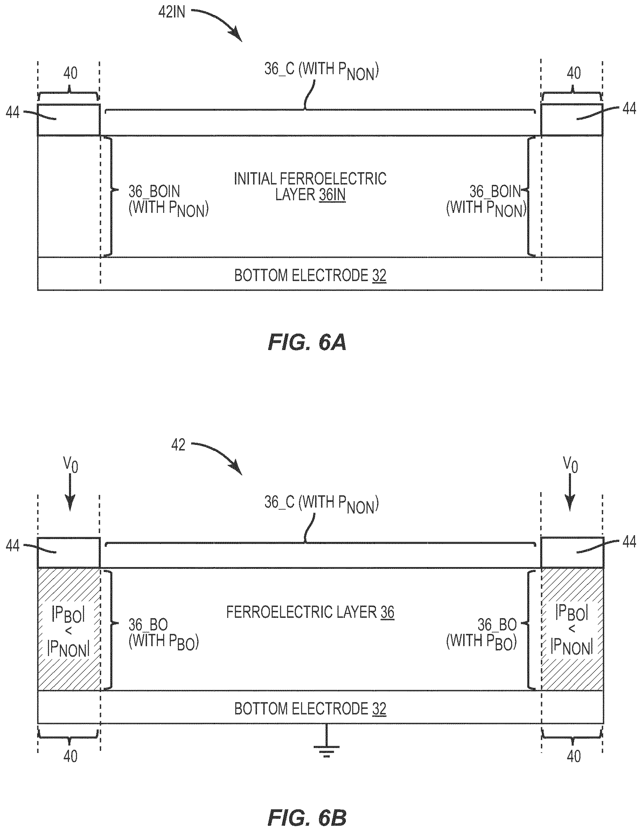

Figures 6A through 6C graphically illustrate an example process for implementing the ferroelectric-based BAW resonator 30 shown in Figure 4 according to some embodiments of the present disclosure. Although the process steps are illustrated in a series, the process steps are not necessarily order dependent. Some steps may be done in a different order than that presented. Further, processes within the scope of this disclosure may include fewer or more steps than those illustrated in Figures 6A-6C.

As illustrated in Figure 6A, the process begins with an initial precursor 42IN, which includes the bottom electrode 32, an initial ferroelectric layer 36IN over the bottom electrode 32, and a bias electrode ring 44 over a periphery of a top surface of the initial ferroelectric layer 36IN. Herein, a region of the initial precursor 42IN, within which the bias electrode ring 44 is located may be referred to the BO region 40.

The initial ferroelectric layer 36IN is formed of a ferroelectric material, which has a box-shape P-E curve (e.g., as shown in Figure 3A), such as ScₓAl₁₋ₓN, PZT, PTO, BTO, HfO₂, or the like. In one embodiment, when the initial ferroelectric layer 36IN is formed of ScₓAl₁₋ₓN, the scandium concentration x might be between 0.1 and 0.8, such as x=0.27, x=0.32, x=0.36, x=0.40, or x=0.43. Herein, the initial ferroelectric layer 36IN includes an initial ferroelectric BO portion 36_BOIN, which is confined within the BO region 40 and aligned underneath the bias electrode ring 44, and the ferroelectric central portion 36_C, which is surrounded by the initial ferroelectric BO portion 36_BOIN and not covered by the bias electrode ring 44. Notice that the entire initial ferroelectric layer 36IN, including the initial ferroelectric BO portion 36_BOIN and the ferroelectric central portion 36_C, has an initial non-zero polarization *P_{NON}.* The bias electrode ring 44 may be composed of one or more ring layers (not shown) and includes at least one metal or alloy, such as Tungsten, Aluminum Copper, and the like.

Next, a DC bias voltage V₀ is applied to the bias electrode ring 44, and the bottom electrode 32 is electrically coupled to ground, such that the initial ferroelectric layer 36IN converts to the ferroelectric layer 36 with the ferroelectric BO portion 36_BO having a polarization *Peo* (the initial precursor 42IN converts to a precursor 42), as illustrated in Figure 6B. The DC bias voltage V₀ changes the electric field between the bias electrode ring 44 and the bottom electrode 32 (i.e., the electric field across the initial ferroelectric BO portion 36_BOIN), but barely changes the electric field across the ferroelectric central portion 36_C. As such, the initial ferroelectric BO portion 36_BOIN with the nonzero polarization *P_{NON}* is capable to convert to the ferroelectric BO portion 36_BO with the zero/small polarization *P_{BO},* while the ferroelectric central portion 36_C remains the initial non-zero polarization *P_{NON},* where an absolute value of *P_{BO}* is less than an absolute value of the initial non-zero polarization *P_{NON}* (|*P_{BO}*|< |*P_{NON}*|). In consequence, the ferroelectric BO portion 36_BO has a zero/small electromechanical coupling coefficient *K_{e_BO}²,* which is smaller than a nonzero electromechanical coupling coefficient *K_{G_NON}²* of the ferroelectric central portion 36_C. The zero/small electromechanical coupling coefficient *K_{e_BO}²* of the ferroelectric BO portion 36_BO will result in no/low BO spurious resonance, while the nonzero electromechanical coupling coefficient *K_{G_NON}²* of the ferroelectric central portion 36_C will provide a main resonance of the final resonator. Herein, the DC bias voltage V₀ is carefully selected, such that the electric field between the bias electrode ring 44 and the bottom electrode 32 will lead to a zero polarization or a small polarization (|*P_{BO}*|< |*P_{NON}*|) within the ferroelectric BO portion 36_BO. The DC bias voltage V₀ is selected based on the material and thickness of the initial ferroelectric layer 36IN.

Notice that, once the polarization *P_{BO}* of the ferroelectric BO portion 36_BO becomes zero or a small value (|*P_{BO}*|< |*P_{NON}*|)*,* there is no need to retain the DC bias voltage V₀ applied to the ferroelectric BO portion 36_BO. After removing the DC bias voltage V₀, the polarization *P_{BO}* of the ferroelectric BO portion 36_BO will remain at zero or the small value, until another DC bias voltage is applied to the ferroelectric BO portion 36_BO.

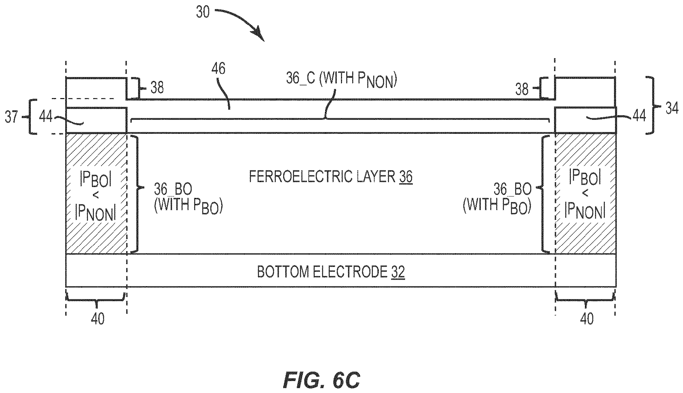

After removing the DC bias voltage V₀, one or more electrode layers 46 are formed over the top surface of the ferroelectric layer 36, as illustrated in Figure 6C. The one or more electrode layers 46 extend over the bias electrode ring 44, and a combination of the one or more electrode layers 46 and the bias electrode ring 44 composes the top electrode structure 34. From shape aspects, the top electrode structure 34 includes the top electrode base 37 over the ferroelectric layer 36 and the BO ring 38 protruding from the periphery of the top electrode base 37. The BO region 40 is the region, within which the BO ring 38 is located. The one or more electrode layers 46 includes at least one metal or alloy, such as Tungsten, Aluminum Copper, and the like.

Notice that a thickness of the bias electrode ring 44 and a thickness of the BO ring 38 may be different or the same. In a desired case, a width of the bias electrode ring 44 and a width of the BO ring 38 may be the same. However, in some applications, the width of the bias electrode ring 44 and the width of the BO ring 38 may be different.

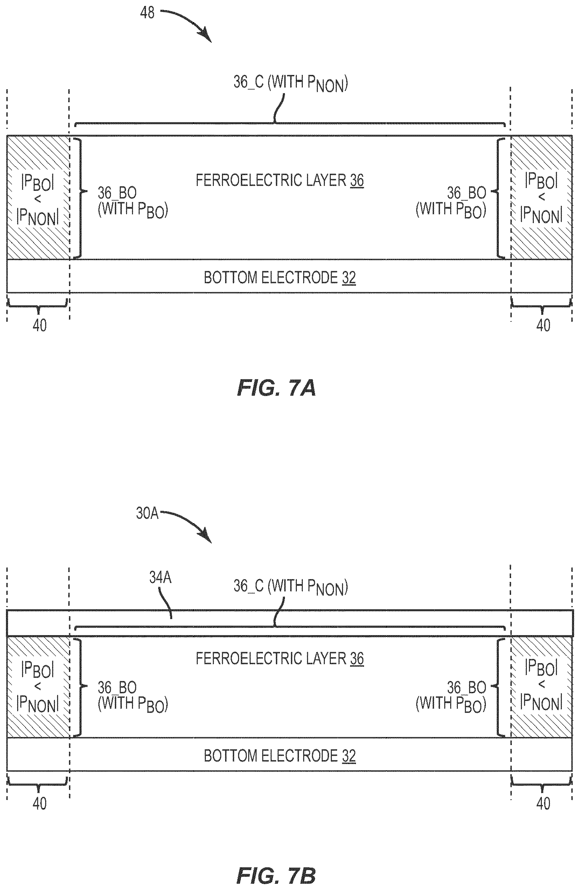

Figures 7A-7B illustrate another example procedure to implement an alternative ferroelectric-based BAW resonator according to some embodiments of the present disclosure. After removing the DC bias voltage V₀, the bias electrode ring 44 might be removed to form an alternative precursor 48, as illustrated in Figure 7A. Herein, the polarization *P_{BO}* of the ferroelectric BO portion 36_BO remains at zero or the small value. Next, an alternative top electrode structure 34A is applied over the top surface of the ferroelectric layer 36 to complete an alternative ferroelectric-based BAW resonator 30A, as illustrated in Figure 7B. The alternative top electrode structure 34A has a flat shape. The alternative top electrode structure 34A may be composed of one or more electrode layers (not shown) and includes at least one metal or alloy, such as Tungsten, Aluminum Copper, and the like.

Due to the zero/small polarization *P_{BO}* of the ferroelectric BO portion 36_BO, the ferroelectric BO portion 36_BO has the zero/small electromechanical coupling coefficient *K_{e_BO}².* And consequently, there will be no or low BO spurious resonances in the alternative ferroelectric-based BAW resonator 30A. Furthermore, even without the BO ring structure, the zero/small polarization *Peo* and accordingly the zero/small electromechanical coupling coefficient *K_{e_BO}²* of the ferroelectric BO portion 36_BO will help confine the energy inside the alternative ferroelectric-based BAW resonator 30A and reduce laterally propagating standing waves. The ferroelectric central portion 36_C in the alternative ferroelectric-based BAW resonator 30A still has the nonzero polarization *P_{NON}* and nonzero electromechanical coupling coefficient *K_{e_NON}²,* and is configured to provide the main resonance of the alternative ferroelectric-based BAW resonator 30A (when an alternating current voltage is applied between the alternative top electrode structure 34A and the bottom electrode 32).

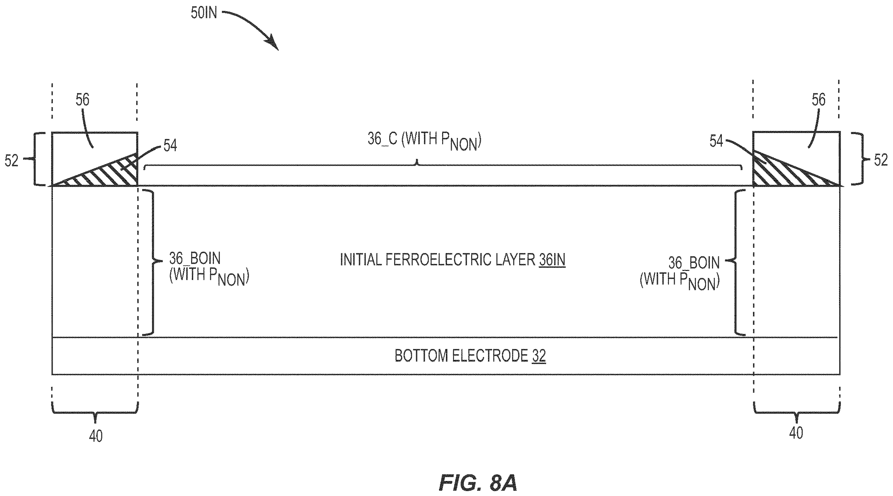

Notice that in both the ferroelectric-based BAW resonator 30 and the alternative ferroelectric-based BAW resonator 30A, the polarization |*P_{BO}*| of the ferroelectric BO portion 36_BO has a constant value (e.g., |*P_{BO}*| = 0 or has a small positive value). In some applications, the polarization within a ferroelectric BO portion may change gradually instead of remaining constant. Figures 8A-8D illustrate an alternative process to implement a second alternative ferroelectric-based BAW resonator according to some embodiments of the present disclosure. Although the process steps are illustrated in a series, the process steps are not necessarily order dependent. Some steps may be done in a different order than that presented. Further, processes within the scope of this disclosure may include fewer or more steps than those illustrated in Figures 8A-8D.

As illustrated in Figure 8A, the alternative process begins with an alternative initial precursor 50IN, which includes the bottom electrode 32, the initial ferroelectric layer 36IN over the bottom electrode 32, and an alternative bias electrode ring 52 over a periphery of the top surface of the initial ferroelectric layer 36IN. Herein, a region of the alternative initial precursor 50IN, within which the alternative bias electrode ring 52 is located may be referred to as the BO region 40.

Compared to the initial precursor 42IN, the initial ferroelectric layer 36IN and the bottom electrode 32 in the alternative initial precursor 50IN remain the same. Herein, the initial ferroelectric layer 36IN includes the initial ferroelectric BO portion 36_BOIN, which is confined within the BO region 40 and aligned underneath the alternative bias electrode ring 52, and the ferroelectric central portion 36_C, which is surrounded by the initial ferroelectric BO portion 36_BOIN and not covered by the alternative bias electrode ring 52.

On the other hand, the alternative bias electrode ring 52 in the alternative initial precursor 50IN is different from the bias electrode ring 44 in the initial precursor 42IN. The bias electrode ring 44 includes one metal or alloy but no dielectric material. On the contrary, the alternative bias electrode ring 52 includes a dielectric portion 54 with a sloped profile and a conducting portion 56. The dielectric portion 54 is deposited on the top surface of the initial ferroelectric layer 36IN within the BO region 40, and is configured to modify the electric field intensity throughout the initial ferroelectric BO portion 36_BOIN when an external DC bias voltage is applied (more details are described below). In one embodiment, a height of the dielectric portion 54 gradually decreases from an interior side of the alternative bias electrode ring 52 towards an outer edge of the alternative bias electrode ring 52. The dielectric portion 54 may be formed of at least one dielectric material, such as silicon nitride (SiN), silicon oxide (SiO₂), and the like. The conducting portion 56 is formed over the dielectric portion 54 and may be formed of at least one metal or alloy, such as Tungsten, Aluminum Copper, and the like.

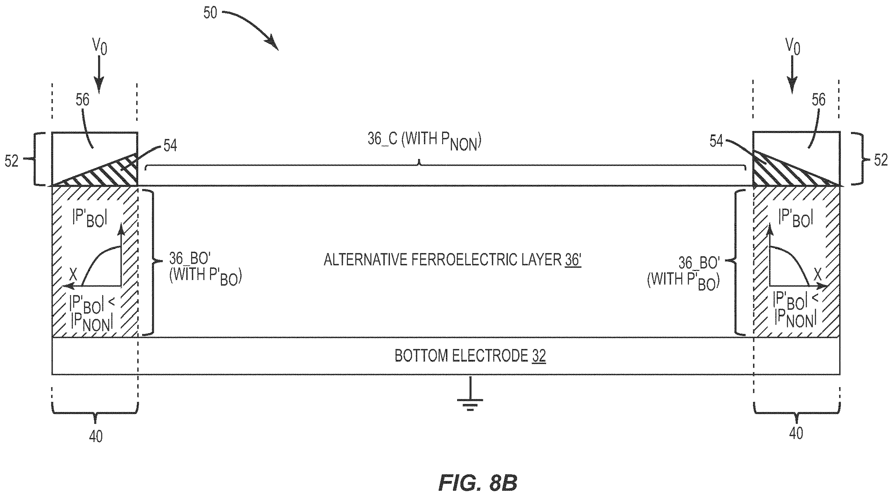

Next, the DC bias voltage V₀ is applied to the alternative bias electrode ring 52, and the bottom electrode 32 is electrically coupled to ground. As such, the initial ferroelectric layer 36IN converts to an alternative ferroelectric layer 36' that includes the ferroelectric central portion 36_C and an alternative ferroelectric BO portion 36_BO' having an alternative polarization *P'_{BO}* (the alternative initial precursor 50IN converts to an alternative precursor 50), as illustrated in Figure 8B. The DC bias voltage V₀ changes the electric field between the alternative bias electrode ring 52 and the bottom electrode 32 (i.e., the electric field across the initial ferroelectric BO portion 36_BOIN), but barely changes the electric field across the ferroelectric central portion 36_C. Herein, since the alternative bias electrode ring 52 includes the sloped dielectric portion 54, when the DC bias voltage V₀ is applied to the alternative bias electrode ring 52, the electric field is uneven throughout the initial ferroelectric BO portion 36_BOIN (e.g., the electric field intensity increases from an interior side of the initial ferroelectric BO portion 36_BOIN towards an outer edge of the initial ferroelectric BO portion 36_BOIN). In consequence, the alternative polarization *P'_{BO}* within the alternative ferroelectric BO portion 36_BO' is not constant, but gradually changes. In one embodiment, an absolute value of the alternative polarization *P'_{BO}* gradually reduces from an interior side of the alternative ferroelectric BO portion 36_BO' towards an outer edge of the alternative ferroelectric BO portion 36_BO'. The minimum value of the alternative polarization *P'_{BO}* might be zero. In consequence, the alternative ferroelectric BO portion 36_BO' also has a gradually varied electromechanical coupling coefficient *K'_{e_BO}² (e.g., K'_{e_BO}²* gradually reduces from the interior side of the alternative ferroelectric BO portion 36_BO' towards the outer edge of the alternative ferroelectric BO portion 36_BO'). The minimum value of the gradually varied electromechanical coupling coefficient *K'_{e_BO}²* might be zero.

Notice that, although the absolute value of the alternative polarization *P'_{BO}* within the alternative ferroelectric BO portion 36_BO' is variable, the absolute value of the alternative polarization *P'_{BO}* is still always less than the absolute value of the initial non-zero polarization *P_{NON}* (|*P'_{BO}*|< |*P_{NON}*|) within the ferroelectric central portion 36_C. In addition, the gradually varied electromechanical coupling coefficient *K'_{e_BO}²* is always smaller than the nonzero electromechanical coupling coefficient *K_{G_NON}²* of the ferroelectric central portion 36_C.

Once the alternative polarization *P'_{BO}* of the alternative ferroelectric BO portion 36_BO' achieves the desired values, there is no need to retain the DC bias voltage V₀ applied to the alternative bias electrode ring 52. After removing the DC bias voltage V₀, the alternative polarization *P'_{BO}* of the alternative ferroelectric BO portion 36_BO' will remain still, until another DC bias voltage is applied to the alternative ferroelectric BO portion 36_BO'.

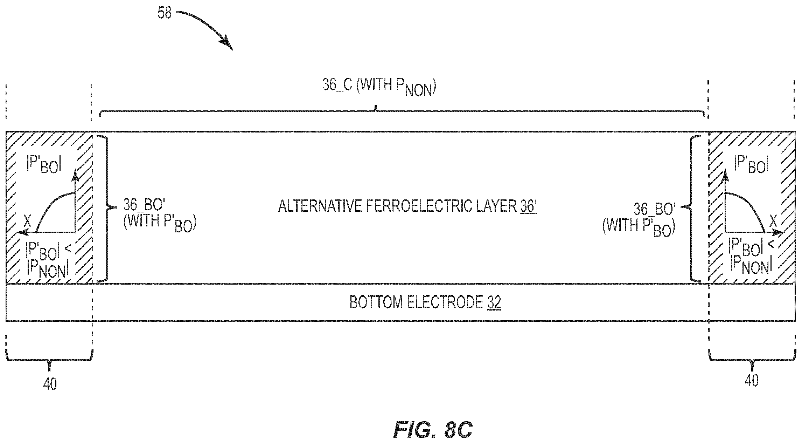

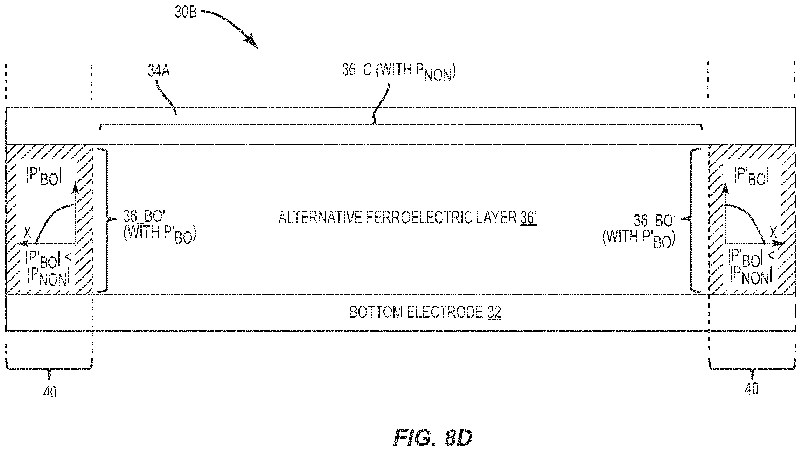

After removing the DC bias voltage V₀, the alternative bias electrode ring 52 might be removed to form an alternative precursor 58, as illustrated in Figure 8C. Herein, the alternative polarization *P'_{BO}* of the alternative ferroelectric BO portion 36_BO' will remain still. Next, the alternative top electrode structure 34A is applied over the top surface of the alternative ferroelectric BO portion 36_BO' to complete a second alternative ferroelectric-based BAW resonator 30B, as illustrated in Figure 8D. The alternative top electrode structure 34A has a flat shape. The alternative top electrode structure 34A may be composed of one or more electrode layers (not shown) and includes at least one metal or alloy, such as Tungsten, Aluminum Copper, and the like.

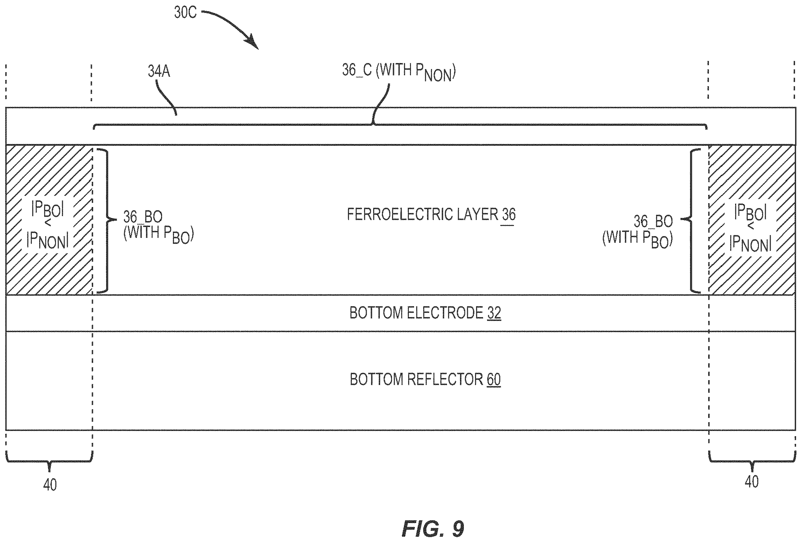

In some applications, a ferroelectric-based BAW resonator may further include one or two reflectors. As illustrated in Figure 9, a third alternative ferroelectric-based BAW resonator 30C, in addition to the bottom electrode 32, the alternative top electrode structure 34A, and the ferroelectric layer 36, also includes a bottom reflector 60 underneath the bottom electrode 32. The bottom reflector 60 may be a Brag reflector. In some applications, the third alternative ferroelectric-based BAW resonator 30C may include the top electrode structure 34 (as shown in Figure 4 or 6C) instead of the alternative top electrode structure 34A over the ferroelectric layer 36 (not shown). In some applications, the third alternative ferroelectric-based BAW resonator 30C may include the alternative ferroelectric layer 36' (as shown in Figure 8D) instead of the ferroelectric layer 36 (not shown).

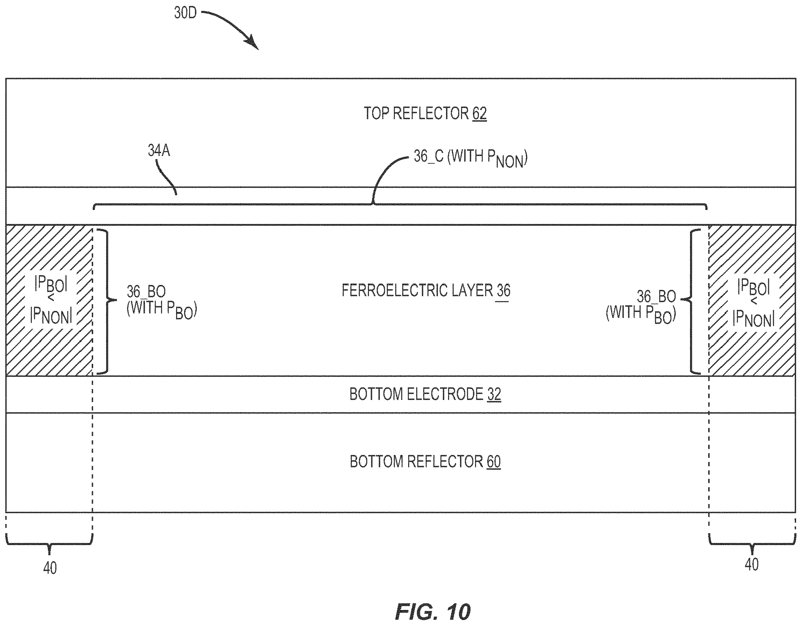

As illustrated in Figure 10, a fourth alternative ferroelectric-based BAW resonator 30D, in addition to the bottom electrode 32, the alternative top electrode structure 34A, and the ferroelectric layer 36, also includes the bottom reflector 60 underneath the bottom electrode 32 and a top reflector 62 over the alternative top electrode structure 34A. The bottom reflector 60 and the top reflector 62 may be Brag reflectors. In some applications, the fourth alternative ferroelectric-based BAW resonator 30D may include the top electrode structure 34 (as shown in Figure 4 or 6C) instead of the alternative top electrode structure 34A sandwiched between the ferroelectric layer 36 and the top reflector 62 (not shown). In some applications, the fourth alternative ferroelectric-based BAW resonator 30D may include the alternative ferroelectric layer 36' (as shown in Figure 8D) instead of the ferroelectric layer 36 (not shown).

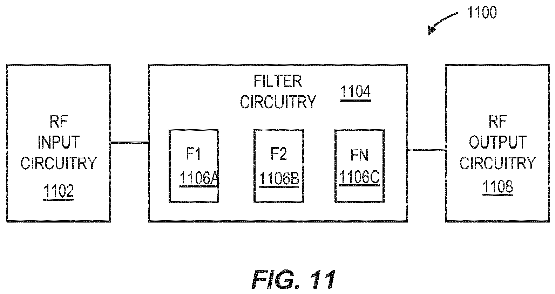

Figure 11 illustrates a block diagram of an example system 1100 that includes at least one BAW filter, which is implemented by one or more ferroelectric-based BAW resonators 30/30A/30B/30C/30D as shown in Figures 4, 7B, 8D, 9, and 10, respectively. The system 1100 includes RF input circuitry 1102 connected to filter circuitry 1104. In certain embodiments, the RF input circuitry 1102 includes a transceiver.

For the purpose of this illustration, the filter circuitry 1104 includes three filters 1106A, 1106B, and 1106C. Herein, one or more of the filters 1106A, 1106B, and 1106C may be BAW filters, which are implemented by one or more ferroelectric-based BAW resonators 30/30A/30B/30C/30D. In different applications, the filter circuitry 1104 may include more or fewer filters. In one embodiment, each of the filters 1106A, 1106B, and 1106C may be a lowpass filter or a bandpass filter, and the filters 1106A, 1106B, and 1106C may be connected in a cascaded arrangement. The filter types that are included in the filter circuitry 1104 may be based at least on the rejection requirements of the system 1100.

The filter circuitry 1104 is connected to an RF output circuitry 1108. In certain embodiments, the RF output circuitry 1108 includes an antenna. The RF input circuitry 1102 and/or the RF output circuitry 1108 may include additional or different components in other embodiments.

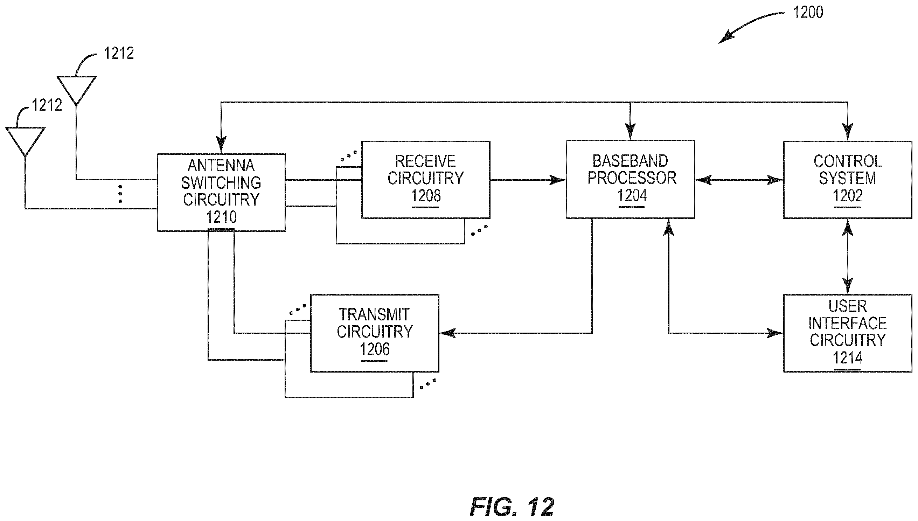

Figure 12 illustrates a block diagram of example user elements that include at least one BAW filter, which is implemented by one or more ferroelectric-based BAW resonators 30/30A/30B/30C/30D shown in Figures 4, 7B, 8D, 9, and 10, respectively. The concepts described above may be implemented in various types of user elements 1200, such as mobile terminals, smart watches, tablets, computers, navigation devices, access points, and like wireless communication devices that support wireless communications, such as cellular, wireless local area network (WLAN), BLUETOOTH, and near field communications. The user elements 1200 will generally include a control system 1202, a baseband processor 1204, transmit circuitry 1206, receive circuitry 1208, antenna switching circuitry 1210, multiple antennas 1212, and user interface circuitry 1214. In a non-limiting example, the control system 1202 can be a fieldprogrammable gate array (FPGA) or an application-specific integrated circuit (ASIC), as an example. In this regard, the control system 1202 can include at least a microprocessor(s), an embedded memory circuit(s), and a communication bus interface(s). The receive circuitry 1208 receives radio frequency signals via the antennas 1212 and through the antenna switching circuitry 1210 from one or more base stations. A low noise amplifier and a filter of the receive circuitry 1208 cooperate to amplify and remove broadband interference from the received signal for processing. Down conversion and digitization circuitry (not shown) will then down convert the filtered, received signal to an intermediate or baseband frequency signal, which is then digitized into one or more digital streams using analog-to-digital converter(s) (ADC).

The baseband processor 1204 processes the digitized received signal to extract the information or data bits conveyed in the received signal. This processing typically comprises demodulation, decoding, and error correction operations, as will be discussed in greater detail below. The baseband processor 1204 is generally implemented in one or more digital signal processors (DSPs) and ASICs.

For transmission, the baseband processor 1204 receives digitized data, which may represent voice, data, or control information, from the control system 1202, which it encodes for transmission. The encoded data is output to the transmit circuitry 1206, where a digital-to-analog converter(s) (DAC) converts the digitally encoded data into an analog signal and a modulator modulates the analog signal onto a carrier signal that is at a desired transmit frequency or frequencies. A power amplifier will amplify the modulated carrier signal to a level appropriate for transmission and deliver the modulated carrier signal to the antennas 1212 through the antenna switching circuitry 1210 to the antennas 1212. The multiple antennas 1212 and the replicated transmit and receive circuitries 1206, 1208 may provide spatial diversity. Modulation and processing details will be understood by those skilled in the art.

It is contemplated that any of the foregoing aspects, and/or various separate aspects and features as described herein, may be combined for additional advantage. Any of the various embodiments as disclosed herein may be combined with one or more other disclosed embodiments unless indicated to the contrary herein.

Those skilled in the art will recognize improvements and modifications to the illustrative embodiments of the present disclosure. All such improvements and modifications are considered within the scope of the concepts disclosed herein and the claims that follow.

Therefore, from one perspective, there have been described approaches for a Bulk Acoustic Wave (BAW) resonator, which includes a bottom electrode, a top electrode structure, and a ferroelectric layer sandwiched in between. Herein, the ferroelectric layer is formed of a ferroelectric material, which has a box-shape polarization-electric field (P-E) curve. The ferroelectric layer includes a ferroelectric border (BO) portion positioned at a periphery of the ferroelectric layer and a ferroelectric central portion surrounded by the ferroelectric BO portion. The ferroelectric BO portion has a first polarization and a first electromechanical coupling coefficient, and the ferroelectric central portion has a second polarization and a second electromechanical coupling coefficient. An absolute value of the first polarization is less than an absolute value of the second polarization, and the first electromechanical coupling coefficient is less than the second electromechanical coupling coefficient. The ferroelectric central portion is configured to provide a resonance of the BAW resonator.

Further examples are set out in the following numbered clauses:
Clause 1. A Bulk Acoustic Wave, BAW, resonator, comprising: a bottom electrode; a top electrode structure; and a ferroelectric layer sandwiched between the bottom electrode and the top electrode structure, wherein: the ferroelectric layer is formed of a ferroelectric material, which has a box-shape polarization-electric field, P-E, curve; the ferroelectric layer includes a ferroelectric border, BO, portion positioned at a periphery of the ferroelectric layer and a ferroelectric central portion surrounded by the ferroelectric BO portion; the ferroelectric BO portion has a first polarization and a first electromechanical coupling coefficient, and the ferroelectric central portion has a second polarization and a second electromechanical coupling coefficient, wherein an absolute value of the first polarization is less than an absolute value of the second polarization, and the first electromechanical coupling coefficient is less than the second electromechanical coupling coefficient; and the ferroelectric central portion is configured to provide a resonance of the BAW resonator.
Clause 2. The BAW resonator of clause 1 wherein the absolute value of the first polarization is constant, and the first electromechanical coupling coefficient is constant.
Clause 3. The BAW resonator of clause 2 wherein the first polarization of the ferroelectric BO portion is a zero polarization, and the first electromechanical coupling coefficient of the ferroelectric BO is a zero electromechanical coupling coefficient.
Clause 4. The BAW resonator of clause 1, 2 or 3 wherein the absolute value of the first polarization gradually reduces from an interior side of the ferroelectric BO portion towards an outer edge of the ferroelectric BO portion, and the first electromechanical coupling coefficient gradually reduces from the interior side of the ferroelectric BO portion towards the outer edge of the ferroelectric BO portion.
Clause 5. The BAW resonator of any preceding clause wherein the top electrode structure comprises a top electrode base over the ferroelectric layer and a BO ring protruding from a periphery of the top electrode base, wherein: a region of the BAW resonator, within which the BO ring is located is a BO region; and the ferroelectric BO portion is confined within the BO region and aligned underneath the BO ring, while the ferroelectric central portion is not covered by the BO ring.
Clause 6. The BAW resonator of any preceding clause wherein the top electrode structure has a flat shape.
Clause 7. The BAW resonator of any preceding clause wherein the ferroelectric material is scandium aluminum nitride, ScxAl1-xN, and the P-E curve of ScxAl1-xN is dependent on a scandium concentration x.
Clause 8. The BAW resonator of any preceding clause further comprises a bottom Brag reflector formed underneath the bottom electrode.
Clause 9. The BAW resonator of clause 8 further comprises a top Brag reflector formed over the top electrode structure.
Clause 10. A method of implementing a Bulk Acoustic Wave, BAW, resonator, comprising: providing an initial resonator precursor, which includes a bottom electrode, an initial ferroelectric layer over the bottom electrode, and a bias electrode ring over a periphery of a top surface of the initial ferroelectric layer, wherein: a region of the initial resonator precursor, within which the bias electrode ring is located is a border, BO, region; the initial ferroelectric layer is formed of a ferroelectric material, which has a box-shape polarization-electric field, P-E, curve; and the initial ferroelectric layer has an initial polarization, and includes an initial ferroelectric BO portion, which is confined within the BO region and aligned underneath the bias electrode ring, and a ferroelectric central portion, which is surrounded by the initial ferroelectric BO portion and not covered by the bias electrode ring; and applying a direct current, DC, bias voltage between the bias electrode ring and the bottom electrode to convert the initial ferroelectric layer to a ferroelectric layer, which includes a ferroelectric BO portion converted from the initial ferroelectric BO portion and the ferroelectric central portion surrounded by the ferroelectric BO portion, wherein: the ferroelectric central portion remains the initial polarization and is configured to provide a resonance of the BAW resonator; and the DC bias voltage is selected, such that an electric field between the bias electrode ring and the bottom electrode leads to a polarization within the ferroelectric BO portion having an absolute value less than an absolute value of the initial polarization within the ferroelectric central portion.
Clause 11. The method of clause 10 further comprising: removing the DC bias voltage; and forming one or more electrode layers over the top surface of the ferroelectric layer, wherein the one or more electrode layers extend over the bias electrode ring, and a combination of the one or more electrode layers and the bias electrode ring composes a top electrode structure over the top surface of the ferroelectric layer.
Clause 12. The method of clause 10 further comprising: removing the DC bias voltage; removing the bias electrode ring to completely expose the top surface of the ferroelectric layer; and forming a top electrode structure over the top surface of the ferroelectric layer, wherein the top electrode structure has a flat shape.
Clause 13. The method of clause 10, 11 or 12 wherein after the DC bias voltage is applied, the absolute value of the polarization within the ferroelectric BO portion is constant.
Clause 14. The method of clause 13 wherein the polarization within the ferroelectric BO portion is a zero polarization.
Clause 15. The method of any of clauses 10 to 14 wherein the ferroelectric material is scandium aluminum nitride, ScxAl1-xN, and the P-E curve of ScxAl1-xN is dependent on a scandium concentration x.
Clause 16. The method of any of clauses 10 to 15 wherein: the bias electrode ring includes a dielectric portion with a sloped profile and a conducting portion; and the dielectric portion is deposited on the top surface of the initial ferroelectric layer within the BO region, and is configured to modify the electric field intensity throughout the initial ferroelectric BO portion when the DC bias voltage is applied.
Clause 17. The method of clause 16 wherein a height of the dielectric portion gradually decreases from an interior side of the bias electrode ring towards an outer edge of the bias electrode ring.
Clause 18. The method of clause 17 wherein after the DC bias voltage is applied, the absolute value of the polarization within the ferroelectric BO portion gradually reduces from an interior side of the ferroelectric BO portion towards an outer edge of the ferroelectric BO portion.
Clause 19. The method of clause 16, 17, or 18 wherein: the dielectric portion is formed of at least one of silicon nitride, SiN, and silicon oxide ,SiO2; and the conducting portion is formed over the dielectric portion and formed of at least one metal or alloy.
Clause 20. The method of any of clauses 16 to 19 further comprising: removing the DC bias voltage; removing the bias electrode ring to completely expose the top surface of the ferroelectric layer; and forming a top electrode structure over the top surface of the ferroelectric layer, wherein the top electrode structure has a flat shape.
Clause 21. A system, comprising: a radio-frequency, RF, input circuitry; a RF output circuitry; and a filter circuitry, which includes at least one Bulk Acoustic Wave, BAW, resonator, connected between the RF input circuitry and the RF output circuitry, wherein the at least one BAW resonator comprises: a bottom electrode; a top electrode structure; and a ferroelectric layer sandwiched between the bottom electrode and the top electrode structure, wherein: the ferroelectric layer is formed of a ferroelectric material, which has a box-shape polarization-electric field, P-E, curve; the ferroelectric layer includes a ferroelectric border, BO, portion positioned at a periphery of the ferroelectric layer and a ferroelectric central portion surrounded by the ferroelectric BO portion; the ferroelectric BO portion has a first polarization and a first electromechanical coupling coefficient, and the ferroelectric central portion has a second polarization and a second electromechanical coupling coefficient, wherein an absolute value of the first polarization is less than an absolute value of the second polarization, and the first electromechanical coupling coefficient is less than the second electromechanical coupling coefficient; and the ferroelectric central portion is configured to provide a resonance of the BAW resonator.

## Claims

1. A Bulk Acoustic Wave, BAW, resonator, comprising:
a bottom electrode;
a top electrode structure; and
a ferroelectric layer sandwiched between the bottom electrode and the top electrode structure, wherein:
the ferroelectric layer is formed of a ferroelectric material, which has a box-shape polarization-electric field, P-E, curve;
the ferroelectric layer includes a ferroelectric border, BO, portion positioned at a periphery of the ferroelectric layer and a ferroelectric central portion surrounded by the ferroelectric BO portion;
the ferroelectric BO portion has a first polarization and a first electromechanical coupling coefficient, and the ferroelectric central portion has a second polarization and a second electromechanical coupling coefficient, wherein an absolute value of the first polarization is less than an absolute value of the second polarization, and the first electromechanical coupling coefficient is less than the second electromechanical coupling coefficient; and
the ferroelectric central portion is configured to provide a resonance of the BAW resonator.

2. The BAW resonator of claim 1 wherein the absolute value of the first polarization is constant, and the first electromechanical coupling coefficient is constant.

3. The BAW resonator of claim 2 wherein the first polarization of the ferroelectric BO portion is a zero polarization, and the first electromechanical coupling coefficient of the ferroelectric BO is a zero electromechanical coupling coefficient.

4. The BAW resonator of claim 1, 2 or 3 wherein the absolute value of the first polarization gradually reduces from an interior side of the ferroelectric BO portion towards an outer edge of the ferroelectric BO portion, and the first electromechanical coupling coefficient gradually reduces from the interior side of the ferroelectric BO portion towards the outer edge of the ferroelectric BO portion.

5. The BAW resonator of any preceding claim wherein the top electrode structure comprises a top electrode base over the ferroelectric layer and a BO ring protruding from a periphery of the top electrode base, wherein:
a region of the BAW resonator, within which the BO ring is located is a BO region; and
the ferroelectric BO portion is confined within the BO region and aligned underneath the BO ring, while the ferroelectric central portion is not covered by the BO ring.

6. The BAW resonator of any preceding claim wherein the top electrode structure has a flat shape.

7. The BAW resonator of any preceding claim wherein the ferroelectric material is scandium aluminum nitride, ScₓAl₁₋ₓN, and the P-E curve of ScₓAl₁₋ₓN is dependent on a scandium concentration x.

8. The BAW resonator of any preceding claim further comprises a bottom Brag reflector formed underneath the bottom electrode, and for example further comprising a top Brag reflector formed over the top electrode structure.

9. A system, comprising:
a radio-frequency, RF, input circuitry;
a RF output circuitry; and
a filter circuitry, which includes at least one Bulk Acoustic Wave, BAW, resonator, according to any preceding claim, connected between the RF input circuitry and the RF output circuitry.

10. A method of implementing a Bulk Acoustic Wave, BAW, resonator, comprising:
providing an initial resonator precursor, which includes a bottom electrode, an initial ferroelectric layer over the bottom electrode, and a bias electrode ring over a periphery of a top surface of the initial ferroelectric layer, wherein:
a region of the initial resonator precursor, within which the bias electrode ring is located is a border, BO, region;
the initial ferroelectric layer is formed of a ferroelectric material, which has a box-shape polarization-electric field, P-E, curve; and
the initial ferroelectric layer has an initial polarization, and includes an initial ferroelectric BO portion, which is confined within the BO region and aligned underneath the bias electrode ring, and a ferroelectric central portion, which is surrounded by the initial ferroelectric BO portion and not covered by the bias electrode ring; and
applying a direct current, DC, bias voltage between the bias electrode ring and the bottom electrode to convert the initial ferroelectric layer to a ferroelectric layer, which includes a ferroelectric BO portion converted from the initial ferroelectric BO portion and the ferroelectric central portion surrounded by the ferroelectric BO portion, wherein:
the ferroelectric central portion remains the initial polarization and is configured to provide a resonance of the BAW resonator; AND
the DC bias voltage is selected, such that an electric field between the bias electrode ring and the bottom electrode leads to a polarization within the ferroelectric BO portion having an absolute value less than an absolute value of the initial polarization within the ferroelectric central portion.

11. The method of claim 10 further comprising:
removing the DC bias voltage; and
one selected from the group comprising:
forming one or more electrode layers over the top surface of the ferroelectric layer, wherein the one or more electrode layers extend over the bias electrode ring, and a combination of the one or more electrode layers and the bias electrode ring composes a top electrode structure over the top surface of the ferroelectric layer; and
removing the bias electrode ring to completely expose the top surface of the ferroelectric layer, and forming a top electrode structure over the top surface of the ferroelectric layer, wherein the top electrode structure has a flat shape.

12. The method of claim 10 or 11 wherein after the DC bias voltage is applied, the absolute value of the polarization within the ferroelectric BO portion is constant, for example wherein the polarization within the ferroelectric BO portion is a zero polarization.

13. The method of any of claims 10 to 12 wherein the ferroelectric material is scandium aluminum nitride, ScₓAl₁₋ₓN, and the P-E curve of ScₓAl₁₋ₓN is dependent on a scandium concentration x.

14. The method of any of claims 10 to 13 wherein:
the bias electrode ring includes a dielectric portion with a sloped profile and a conducting portion; and
the dielectric portion is deposited on the top surface of the initial ferroelectric layer within the BO region, and is configured to modify the electric field intensity throughout the initial ferroelectric BO portion when the DC bias voltage is applied;
and, for example, wherein a height of the dielectric portion gradually decreases from an interior side of the bias electrode ring towards an outer edge of the bias electrode ring, and for example wherein, when not dependent from claim 13, after the DC bias voltage is applied, the absolute value of the polarization within the ferroelectric BO portion gradually reduces from an interior side of the ferroelectric BO portion towards an outer edge of the ferroelectric BO portion.

15. The method of claim 14 wherein:
the dielectric portion is formed of at least one of silicon nitride, SiN, and silicon oxide ,SiO₂; and
the conducting portion is formed over the dielectric portion and formed of at least one metal or alloy.
